# EUROPEAN PATENT APPLICATION

(11) **EP 1 383 236 A1**
(43) Date of publication of application: **21.01.2004**
(21) Application number: 02254998.4
(22) Date of filing: 16.07.2002
(51) Int. Cl.: H03H 7/01, H04B 1/18, H03J 5/24, B81B 7/02, H01H 59/00

(54) **Reconfigurable multibandfilter**

(71) Applicant: LUCENT TECHNOLOGIES INC., Murray Hill, New Jersey 07974-0636 (US)
(72) Inventor: Franz Eckl, Wolfgang, Spardorf 91080 (DE); Fischer, Georg, Nurnberg, 90419 Bavaria (DE); Kaminski, Gerhard, Fuerth 90765 (DE)
(74) Representative: Sarup, David Alexander

(57) **Abstract**

The invention relates to a re-configurable filter.

An object of the invention is, to provide a new and improved approach for providing an increased reconfiguration flexibility with regard to a filter, in particular to a bandpass-filter for different high-frequency or radio-frequency bands, in particular suitable for use within the transceiver of base stations and/or user terminals, such as handsets adapted to be used within these communication systems, by preferably simultaneously reducing undesirable parasitic influences.
The invention proposes a reconfigurable multibandfilter, in particular adapted for filtering high-frequency and/or radio-frequency comprising at least two filters (f1, f2, f3) connected at their input ports in parallel (1) into a signal path, and at least one controllable switching means for individually connecting (2) respectively one of the filter output ports into said signal path with the other filter output ports disconnected from said signal path and in particular connected to ground (3).

## Description

The invention relates to a re-configurable multibandfilter.

In particular with regard to mobile communication systems, such as based on a GSM (Global System for Mobile communications), UMTS (Universal Mobile Telecommunication Systems), WCDMA (Wideband Code Division Multiple Access) and/or CDMA 2000 standard there is a permanently increasing need to design re-configurable multiband and/or multistandard mobile communication systems. This for example, is based on the fact that on the one hand side more and more frequency bands are opened up and being licensed for mobile communication and on the other hand side several standards are provided in parallel between which the customers would like to select.

However, until today for every new frequency band an individual radio has to be designed that forces a complex infrastructure and terminal vendor to a great variety of products, in particular in terms of base stations and/or user terminals, such as handsets adapted to be used within these communication systems.

As a consequence, there is a need both for new receiving and/or transmitting architectures in particular for ensuring re-configurability in terms of frequency bands and system standards and for improved flexible circuits in particular for optimization, tuning and/or matching purposes.

Moreover, even with regard to other high frequency receiving/transmitting-systems for data transmission there is an increased need for receiver and/or transmitter chains, which provide a flexibility in use by re-configurability and by tuning and/or matching functionality for optimization.

Based on the above needs, in particular with regard to upcoming multiband and/or multistandard systems, one of the major task is to re-configure the respective incorporated bandpass-filter for different frequency bands. Accordingly, a filter itself, in particular bandpass-filter should be re-configurable.

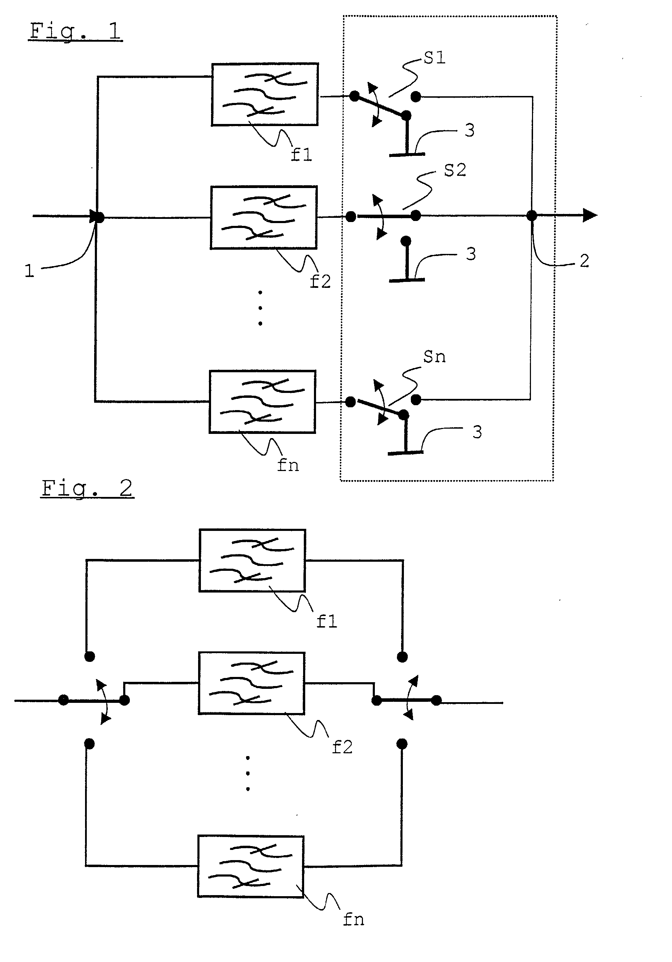

Nowadays however, the solution to re-configure bandpass-filter for different frequency bands is however, to design a lot of separate bandpass-filters for every band and to switch them individually at the filter input and at the filter output into the signal path, wherein respectively only one bandpass-filter is in the signal path, as it is indicated in the appended Fig. 2.

However, especially for those filters, which are used in the receiver part of a transceiver, the overall insertion loss in the wanted, receive part is crucial because every dB of insertion loss will decrease the receiver sensitivity by the same amount. Therefore the usage of two switches in series, i.e. at the filter input and at the filter output, will degrade the receiver performance.

Moreover, the switches in such a configuration, as indicated in Fig. 2, must have a high isolation in the off state. The isolation, combined with the filters, which are not switched in the signal path, causes a decrease of the stopband attenuation of the filter that is switched into the signal path.

An object of the invention is therefore to provide, in particular with regard to the above discussed state of the art, a new and improved approach for providing an increased reconfiguration flexibility with regard to a filter, in particular to a bandpass-filter for different high-frequency or radio-frequency bands, in particular suitable for use within the transceiver of base stations and/or user terminals, such as handsets adapted to be used within these communication systems, by preferably simultaneously reducing undesirable parasitic influences.

The inventive solution is achieved by a reconfigurable multibandfilter comprising the features of claim 1, by a switching bank comprising the features of claim 4 and/or by a method comprising the features of claim 10.

Advantageous and/or preferred embodiments or refinements are the subject matter of the respective dependent claims.

Accordingly, the invention proposes a reconfigurable multibandfilter, in particular adapted for filtering high-frequency and/or radio-frequency comprising at least two filters connected at their input ports in parallel into a signal path, and at least one controllable switching means for individually connecting respectively one of the filter output ports into said signal path with the other filter output ports disconnected from said signal path.

One of the main advantages is, that due of the use of switching means only at the output port or side of the filters, only one switch is in the signal path, so that additional insertion loss caused by the switches is effectively reduced than in the state of the art.

According to preferred refinements it is proposed to realize each of the filters as bandpass filter, in particular having a definable filter frequency. Moreover, in particular when using bandpass filters it is further proposed, to provide for each filter output a switch, which is controllable in that each filter output port is separately connectable into the signal path or to ground.

Thus, only one filter is switched into the signal path, with the other filters are shorted to ground at their outputs. Accordingly, the shorted bandpass filters are then converted to notch filters improving the stopband attenuation of the one filter, which is connected into the signal path. Moreover, since the switches short the unused bandpass filters or converted filters to ground, the isolation of the switches is much less important.

As a consequence, the robustness of the receiver to interference from other bands is increased, and stopband requirements for single filters may be reduced.

Preferably, by using controllable switching means with an actuator and a contact element to close or open the switching means for the individually connecting and disconnecting it can be easily ensured, that the control signal path for controlling the switching means can be isolated from the high frequency signal path. In particular based thereon, the actuating mechanisms means are advantageously realized by using MEMS (Micro-Electro-Mechanical-Systems) actuators leading to very small parasitic effects.

The invention proposes further to provide a switching bank comprising at least two switching means each of which provides a first connecting port and a second connecting port, wherein the second connecting port is controllable switchable between a common signal path and ground.

Such switching bank then is easily connectable with a plurality of filters or with a correspondingly adapted filter bank, in particular for the inventive filtering approach of high-frequency and/or radio-frequency, by connecting at least two filters at their respective input ports in parallel into the signal path, and by controllable connecting respectively one of the filter output ports into the signal path with the other filter output ports shorted to ground.

For the praxis, it is suggested, to provide at least one separate control path for controlling respectively one switch and/or at least one control bus for controlling a plurality of switches. Preferably, the at least one control bus for the plurality of switches is preferably based on a sufficient number of bits for controlling each of the switches individually, wherein the at least one control bus is advantageously connectable to a EPROM or EEPROM, so that application specific and/or desired filtering conditions of the inventive device can be retrievable stored.

Additionally, by the incorporation of the inventive device into a rf-system, sensitive rf-parameters may easily be tuned for optimization purposes, instead of individually designing and optimizing a plurality of filter circuits. This enables, even with regard to the manufacture, a significant reduction of development costs and the possibility of compensating tolerances.

According to preferred refinements, it is proposed to fabricate the inventive device by using a so called Micro-Electro-Mechanical-Systems (MEMS) technology. This enables the possibility to integrate the complete structure of the reconfigurable multibandfilter or at least of the switching bank into one physical part or package.

In addition, due to the integration of all these components into one package the dimensions are extremely small with regard to the high frequencies and hence high frequency signal based parasitic effects caused by large transmission lines are significantly reduced.

Additionally, there is only a very low amount of board space necessary for the implementation. As a result, in particular with regard to multiband and/or multistandard purposes the invention provides a cost saving and board space saving solution, since the implementation of several individual filter devices which would have to be switched at their respective output for respectively covering one band is avoided.

Moreover, since two ports are sufficient for the input and output of the signal path with regard to the entire inventive device, problems for implementing the inventive device within a further layout are significantly reduced, too.

Moreover, by using such MEMS technology all internal parasitics are well defined and in comparison with the state of the art, a production spread usually is avoided. The invention proposes further to produce the filters and/or the switches as three-dimensional mechanical structures, in particular by employing a bulk micro machining and/or a surface micro machining technology.

According to preferred embodiments the actuating mechanisms means respectively comprises a mechanism based on an electrostatic, piezoelectric, thermal, magnetic or bi-metallic actuator functionality.

As a consequence, by preferably using the technique of Micro-Electro-Mechanical-Systems for the integration of the components into one package, a versatile electrical filtering device for high-frequency is provided, with the advantages of a very high isolation between the controlling paths and high-frequency paths and of a less insertion loss.

Hence, low tolerance components with well defined internal parasitics are achieved which can be used in several application areas of a receive/transmit chain.

A further advantage of providing the inventive device as a MEMS-based device is, that such a MEMS-based device provides the possibility for an easy combination with further circuits, especially application specific circuits, based on Silicon, CMOS and/or BICMOS (Bipolar-CMOS) technology for example, especially allowing the integration of some control logic for a digital port.

Such preferred application areas are especially the use within a communication system and/or network, in particular a mobile communication system and/or network based on a GSM, UMTS, WCDMA and/or CDMA 2000 standard, in particular adapted for use within a receive and/or transmit radio unit of a mobile communication system, within a base station or within a user terminal in particular adapted for use within a mobile communication system.

Subsequently, the invention is exemplary described in more detail based on a preferred embodiment and with regard to the appended drawing, in which:
- Fig. 1: is schematically depicting a preferred inventive embodiment of a reconfigurable multibandfilter with low insertion loss and improved stopband attenuation, and
- Fig. 2: is schematically depicting the state of the art solution to a multibandfilter.

Regarding FIG. 1, a preferred but exemplar embodiment of a reconfigurable multibandfilter according to the invention with low insertion loss and improved stopband attenuation incorporates the integration of three high-frequency switches S1, S2, Sn and of three high-frequency bandpass filters f1, f2, fn into one physical part or package fabricated on the basis of the so called MEMS (Micro-Electro-Mechanical-Systems) technology.

As can be seen from FIG. 1, each input port of the three high-frequency filters f1, f2, fn is connected, as indicated by reference sign 1, in parallel into a signal path and each output port of the three high-frequency filters f1, f2, fn is connected to a respective first connecting port of one of the high-frequency switches S1, S2, Sn.

The respective second connecting port of each of the high-frequency switches S1, S2, Sn is controllable and selectable switchable between said signal path, as indicated by reference sign 2, and ground 3 such that respectively one of the filters f1, f2, fn is connected with its output port into the signal path and the other filters f1, f2, fn are connected with their output ports to ground 3.

According to the example of Fig. 1, the output port of filter f2 is connected into the signal path and hence, the entire multibandfilter is switch to the frequency band f2.

Since the other two bandpass filters f1 and fn are connected by the switches S1 and Sn to ground 3, these unused bandpass filters f1 and fn are converted to or reused as notch filters and hence, improve the stopband attenuation of the filter f2, which is switched into the signal path by the switch S2. Moreover, because the switches S1 and Sn short the unused bandpass filters f1 or fn to ground 3, the isolation of the switches is much less important.

Each of the switches S1, S2, Sn is controllable based on an actuator part causing a contact part of the switch to close or open the switch, wherein the drive of the actuator part is de-coupled from the signal path, as described below.

Furthermore, the switches S1, S2, Sn responsible for connecting or disconnecting the respective associated filter f1, f2 or fn into the signal path or from the signal path to ground 3 are preferably controlled by a bus, for example a 3-bit bus for controlling each of the switches S1, S2, Sn individually.

Moreover, such a control bus is preferably connected to an EPROM or even an EEPROM for retrievable storing different operating, i.e. filtering conditions. Thus if an application specific operating condition is desired, the correspondingly stored condition can be activated in a simple manner by use of such (E)EPROM.

However, each of the switches S1, S2, Sn may be alternatively controlled by a separate control path.

The entire reconfigurable multibandfilter or at least the switching bank, as indicated by the dotted line, to which a plurality of filters or a correspondingly adapted filter bank is connectable, is preferably produced as one physical part or package, especially by providing 3-dimensional mechanical structures for example based on a bulk micromachining technology and/or a surface micromachining technology, resulting in very small dimensions.

In particular, in bulk micromachining these structures, the filters f1, f2, fn and in particular the switches S1, S2, Sn may be sculpted within the confines of a wafer by exploiting the anisotropic edging rates of different atomic crystallographic plans in the wafer. On the other hand side, the structures may be formed by the process of fusion bonding, which entails building up a structure by atomically bonding various wafers.

According to the surface micromachining based MEMS technology the 3-dimensional mechanical structures may be built up by the orchestrated addition and removal of a sequence of thin film layers to or from a wafer surface.

As a further alternative the mechanical structures may be fabricated by using thick photoresists which are exposed to X-rays to produce molds that are subsequently used to form high-aspect ratio electroplated 3-dimensional structures.

In this regard, i.e. based on a Micro-Electro-Mechanical-Systems-technology, the switches S1, s2, Sn can be designed with a very low insertion loss, a high linearity and a high isolation, in particular with regard to the control signal transmitted to the switch actuators, that is essentially absolutely de-coupled or isolated from the switch contacts and hence, from the high-frequency or radio-frequency signal path.

The actuators of the switches S1, S2, Sn may be based on a plurality of structures including a cantilever, a membrane, a shape-memory alloy and/or a multi-pole/multi-throw.

As a preferred actuation mechanism an electrostatic mechanism is used, i.e. a positive and/or negative charge applied by a control voltage between certain structural members of the MEMS switches elicit coulomb forces which produce motion. As an alternative, the actuation mechanism may be based on a piezoelectric effect, i.e. the control voltage is applied on a certain structure of a respective MEMS switch for inducing a field, which changes the physical dimensions of the structure to communicate motion. As further exemplar alternatives, a control current can be forced through a certain element of a respective MEMS switch causing it to heat up and expand with the physical dimensional change used to communicate motion or a control signal can induce a magnetic force producing motion.

Hence, a number of actuation mechanisms may be used for high frequency MEMS device applications. However, an electrostatic based actuation is one of the most preferred actuation mechanisms and surface micromachining, which is preferably used for producing electrostatically-based actuators is compatible with integrated circuit fabrication processes.

Furthermore, the MEMS switches S1, S2, Sn can be used with resistive or metal to metal contact areas and/or with capacitively-coupled switching areas in which the contact is made via an insulating dielectric layer.

By using the MEMS-technology, substantially all internal parasitics of the MEMS structures are well defined without production spread in substantial, so that low tolerance components are achieved such that the complete configuration is universal in terms of reconfiguration and optimization and can be used in re-configurable and/or tunable systems and/or in several areas of a receive/transmit chain, in particular within applications where the reconfiguration and/or tuning requirements are not critical with regard to time, since the mechanical structures or components may introduce a kind of mechanical inertia.

It is mentioned, that even if the invention is described with regard to the example schematically depicted in Fig. 1, the invention also comprises embodiments incorporating a different number of components.

## Claims

1. Reconfigurable multibandfilter, in particular adapted for filtering high-frequency and/or radio-frequency comprising at least two filters (f1, f2, f3) connected at their input ports in parallel (1) into a signal path, and at least one controllable switching means for individually connecting (2) respectively one of the filter output ports into said signal path with the other filter output ports disconnected from said signal path.

2. Reconfigurable multibandfilter of claim 1, comprising at least one control signal path isolated from the signal path into which the respectively one filter output port is connectable for controlling the switching means (S1, S2, Sn).

3. Reconfigurable multibandfilter of any of the preceding claims, wherein each filter (f1, f2, f3) is a definable bandpass filter and each disconnected filter output port is shorted to ground (3) and/or wherein each filter output port is separately connected to a controllable switching means for switching each filter output port into the signal path or to ground (3).

4. Switching bank comprising at least two switching means (S1, S2, Sn) each of which provides a first connecting port and a second connecting port, wherein the second connecting port is controllable switchable between a common signal path (2) and ground (3).

5. Reconfigurable multibandfilter of any of the preceding claims and/or switching bank of the preceding claim, comprising at least one separate control path for controlling respectively one switching means (S1, S2, Sn) and/or at least one control bus for controlling a plurality of switching means (S1, S2, Sn), in particular with the at least one control bus connectable to a control logic, in particular using an EPROM or EEPROM.

6. Reconfigurable multibandfilter of any of the preceding claims and/or switching bank of claims 4 or 5, wherein the switching means (S1, S2, Sn) respectively comprises an actuator for driving a contact element of the switching means (31, 52, Sn) to close or open the switching means (S1, S2, Sn).

7. Reconfigurable multibandfilter of any of the preceding claims and/or switching bank of any of the preceding claims 4 to 6, wherein the switching means (S1, S2, Sn) respectively comprises an actuating mechanism based on an electrostatic, piezoelectric, thermal, magnetic or bi-metallic actuator functionality.

8. Reconfigurable multibandfilter of any of the preceding claims and/or switching bank of any of the preceding claims 4 to 7, wherein the controllable switching means (S1, S2, Sn) is produced as MEMS rf-switch means and/or the filters (f1, f2, fn) are produced as MEMS-filters.

9. Reconfigurable multibandfilter of any of the preceding claims and/or switching bank of any of the preceding claims 4 to 8, produced by using a Micro-Electro-Mechanical-Systems (MEMS) technology, in particular produced by employing a bulk micromachining and/or a surface micromachining technology.

10. Method of filtering high-frequency and/or radio-frequency, comprising the steps of connecting at least two filters (f1, f2, fn) at their respective input ports in parallel (1) into a signal path, controllable connecting respectively one of the filter output ports into the signal path with the other filter output ports shorted to ground (3).
